# EUROPEAN PATENT APPLICATION

(11) **EP 4 498 417 A1**
(43) Date of publication of application: **29.01.2025**
(21) Application number: 24165848.3
(22) Date of filing: 25.03.2024
(51) Int. Cl.: H01L 21/78, H01L 23/36, H01L 21/683, H01L 21/56

(54) **CHIP STRUCTURE AND METHOD OF MANUFACTURING THE SAME**

(30) Priority: 25.07.2023 TW 112127849
(71) Applicant: Chipbond Technology Corporation, 300 Hsinchu (TW)
(72) Inventor: SHIH, Cheng-Hung, Lugang Township, Changhua County (TW); HSIEH, Yung-Wei, Hsinchu City (TW); SHIH, Chia-Ling, Hsinchu City (TW)
(74) Representative: Beck & Rössig European Patent Attorneys

(57) **Abstract**

In a method of manufacturing a chip structure, a first carrier is attached on a back surface of a wafer, the wafer is diced into individual dies and there is a groove formed between the adjacent dies, then a second carrier is attached on an active surface of the wafer and the first carrier is removed to expose the groove, a back surface and a lateral surface of each of the dies, a heat dissipation cover is formed on the back surface and the lateral surface of each of the dies to obtain chip structures. The heat dissipation cover is provided to increase heat dissipation efficiency of the dies and prevent formation of metal debris which may contaminate the dies. Furthermore, the heat dissipation cover is prevented from being separated from the die. The application also discloses chip structure.

## Description

### FIELD OF THE INVENTION

This invention relates to a chip structure and a method of manufacturing the same, which can increase heat dissipation efficiency, avoid formation of metal debris, and protect a heat dissipation cover from separating from a die.

### BACKGROUND OF THE INVENTION

Conventionally, chips are designed to have faster computing speeds and become smaller and thinner, but it is not easy to dissipate heat generated in chips. If chip operating temperature is too high, the chip may be damaged, or its computing speed may be slow down.

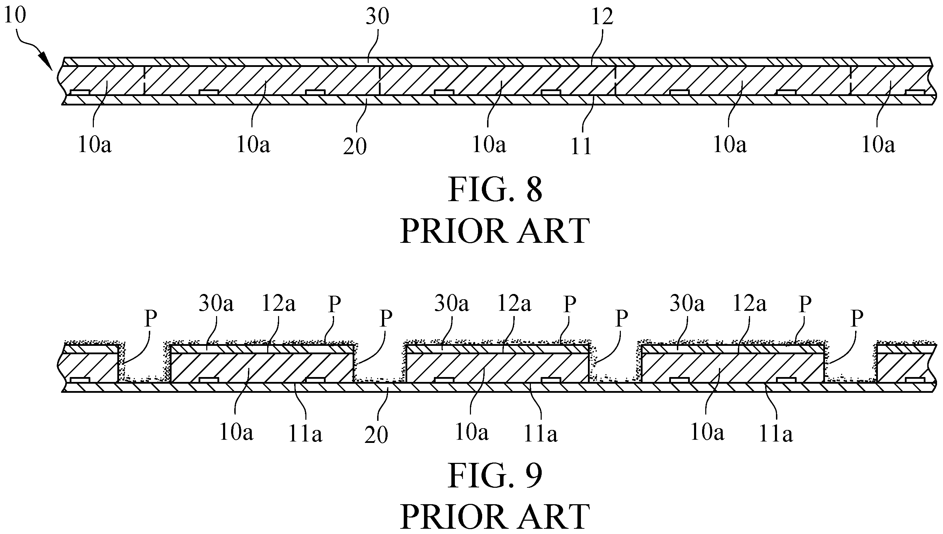

As shown in Fig. 8, before a dicing process, an active surface 11 of a wafer 10 is attached onto a carrier 20 to allow a backside 12 of the wafer 10 to be visible, and then a heat dissipation layer 30 is provided on the backside 12 for improving heat dissipation performance. Referring to Fig. 9, in the dicing process, the wafer 10 is diced into individual dies 10a by a dicing saw (not shown), at the same time, the heat dissipation layer 30 is also diced into heat dissipation sheets 30a by the dicing saw. Each of the heat dissipation sheets 30a is located on a back surface 12a of one of the individual dies 10a. Owing to the heat dissipation sheets 30a are formed during dicing the wafer 10, heat dissipation area of each of the heat dissipation sheets 30a is identical to the area of the back surface 12a of each of the dies 10a, that will restrict heat dissipation performance of the dies 10a.

With reference to Figs. 8 and 9, because the heat dissipation layer 30 is formed on the backside 12 of the wafer 10 before the dicing process, metal debris P are usually generated on the heat dissipation layer 30 while the heat dissipation layer 30 is diced with the wafer 10 by the dicing saw, and the metal debris P may adhere on the carrier 20 and exposed surfaces of the dies 10a.

With reference to Fig. 9, during pick and place process, the metal debris P on the carrier 20 and the dies 10a may contaminate an active surface 11a of the dies 10a. Otherwise, stress generated during the heat dissipation layer 30 is diced by the dicing saw may cause the heat dissipation sheets 30a to separate from the dies 10a and lower quality and yield of the dies 10a.

### SUMMARY OF THE INVENTION

One object of the present invention is to provide a chip structure and a method of manufacturing the same. After dicing a wafer into individual dies, a heat dissipation cover is provided on a back surface and a lateral surface of each of the dies to increase heat dissipation area and efficiency. Owing to the heat dissipation cover is not cut, no metal debris will be generated on the heat dissipation cover. Furthermore, mechanical strength of the heat dissipation cover can be improved to prevent the heat dissipation cover from separating from the die.

A method of manufacturing a chip structure of the present invention includes the steps as follows. A wafer including multiple dies is attached onto a first carrier, a back surface of each of the dies is attached on the first carrier, and an active surface of each of the dies is visible. The wafer is diced into multiple singulated dies along a dicing lane which is located on the active surface of the dies and located between the adjacent dies, a groove is formed between the adjacent singulated dies, and a lateral surface of each of the dies is visible from the groove. The wafer is attached onto a second carrier to allow the active surface of each of the singulated dies is attached on the second carrier. The first carrier is removed to expose the groove, the back surface and the lateral surface of each of the singulated dies. Heat dissipation covers are provided on the singulated dies to constitute multiple chip structures, each of the heat dissipation covers is directly formed on the back surface and the lateral surface of one of the singulated dies to cover the back surface and the lateral surface. Each of the heat dissipation covers includes a first portion, a second portion and a connection portion which is located between and connected to the first and second portions. The first portion is formed on the back surface, the second portion is formed on the lateral surface via the groove, and the connection portion is formed on an outer corner of the back surface. A first space exists between the connection portions of the adjacent heat dissipation covers, a second space exists between the second portions of the adjacent heat dissipation covers, the first space is less than the second space, and the first and second spaces become smaller gradually from the second carrier to an opening of the groove. A first exposed surface of the first portion is connected to a third exposed surface of the connection portion, and a second exposed surface of the second portion is connected to a fourth exposed surface of the connection portion. The first portion has a first thickness in a direction perpendicular to the back surface, and the second portion has a second thickness in a direction parallel to the back surface. The second thickness is less than the first thickness and is reduced gradually from the connection portion to the active surface, thus the second exposed surface of the second portion extends toward the second carrier obliquely.

A chip structure of the present invention is manufactured through the method mentioned above. The chip structure includes a die and a heat dissipation cover which is directly formed on a back surface and a lateral surface of the die to cover the back surface and the lateral surface. The heat dissipation cover includes a first portion, a second portion and a connection portion which is located between and connected to the first and second portions. The first portion is located on the back surface, the second portion is located on the lateral surface, and the connection portion is located on an outer corner of the back surface. A first exposed surface of the first portion is connected to a third exposed surface of the connection portion, and a second exposed surface of the second portion is connected to a fourth exposed surface of the connection portion. The first portion has a first thickness in a direction perpendicular to the back surface, and the second portion has a second thickness in a direction parallel to the back surface. The second thickness is less than the first thickness and is reduced gradually from the connection portion to an active surface of the die. An acute angle exists between the second exposed surface of the second portion and the lateral surface of the die.

In the present invention, the heat dissipation cover is formed on the back surface and the lateral surface of each of the dies after dicing the wafer, so metal debris caused by cutting the heat dissipation cover will not be generated and the heat dissipation cover will not separate from the die due to the stress generated during cutting the heat dissipation cover. Additionally, because of the second portion and the connection portion of the heat dissipation cover, heat dissipation area and mechanical strength of the heat dissipation cover can be increased to prevent the heat dissipation cover from separating from the die.

### BRIEF DESCRIPTION OF DRAWING

Figs. 1 to 5 are cross-section view diagrams illustrating a method of manufacturing a chip structure in accordance with one embodiment of the present invention.
Figs. 6 and 7 are cross-section view diagrams illustrating a chip structure in accordance with one embodiment of the present invention.
Figs. 8 and 9 are cross-section view diagrams illustrating a conventional chip structure.

### DETAILED DESCRIPTION OF THE INVENTION

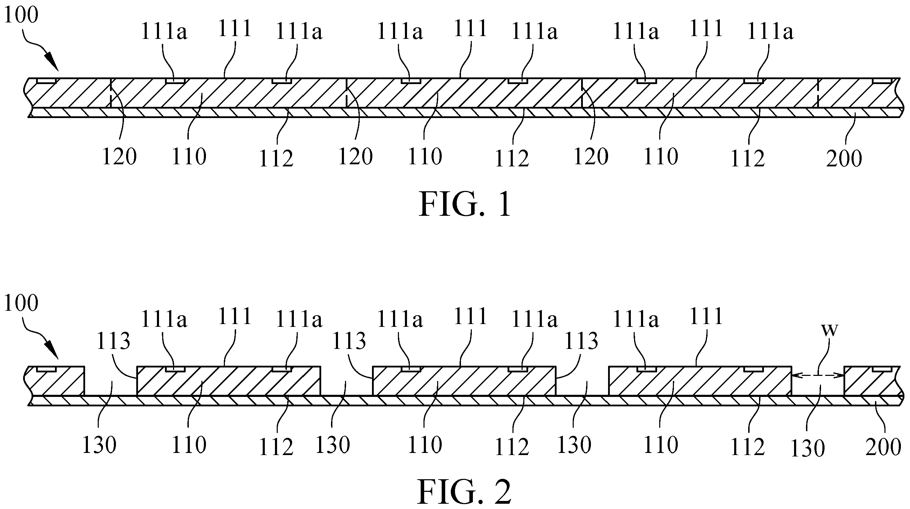

As shown in Figs. 1 to 7, the present invention discloses a method of manufacturing a chip structure A which includes a heat dissipation cover.

With reference to Fig. 1, firstly, a wafer 100 including a plurality of dies 110 is attached onto a first carrier 200 which may be an adhesive tape. Preferably, a back surface 112 of each of the dies 110 is attached on the first carrier 200, and an active surface 111 of each of the dies 110 is visible. There are multiple conductive pads 111a on the active surface 111 of each of the dies 110, and redistribution layers and/or bumps (not shown) which are electrically connected to the conductive pads 111a can be provided on the active surface 111.

With reference to Figs. 1 and 2, a dicing process is performed after attaching the wafer 100 onto the first carrier 200. In the direction from the active surface 111 to the back surface 112, the wafer 100 is diced to singulate the dies 110 along a dicing lane 120 on the active surface 111 of each of the dies 110 and located between the adjacent dies 110 by a dicing saw (not shown). In addition, a groove 130 is formed between the adjacent dies 110 after the dicing process, and the first carrier 200 and a lateral surface 113 of each of the dies 110 are visible from the groove 130.

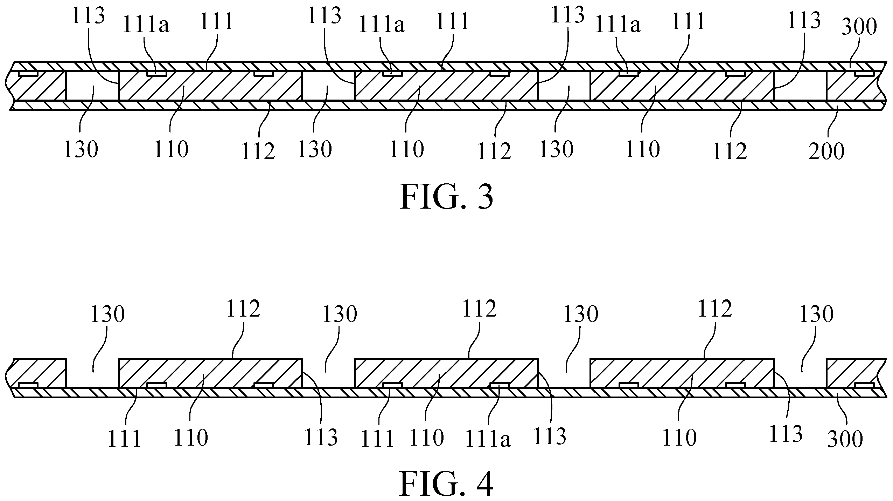

With reference to Fig. 3, then the diced wafer 100 is attached onto a second carrier 300 which may be also an adhesive tape. The active surface 111 of each of the dies 110 is preferably attached on the second carrier 300 such that the active surface 111 and the groove 130 are covered by the second carrier 300.

With reference to Fig. 4, the first carrier 200 is removed to expose the back surface 112 and the lateral surface 113 of each of the dies 110 and the groove 130 located between the adjacent dies 110. In this embodiment, the first carrier 200 is removed after inverting the wafer 100, the first carrier 200 and the second carrier 300 which are attached with each other.

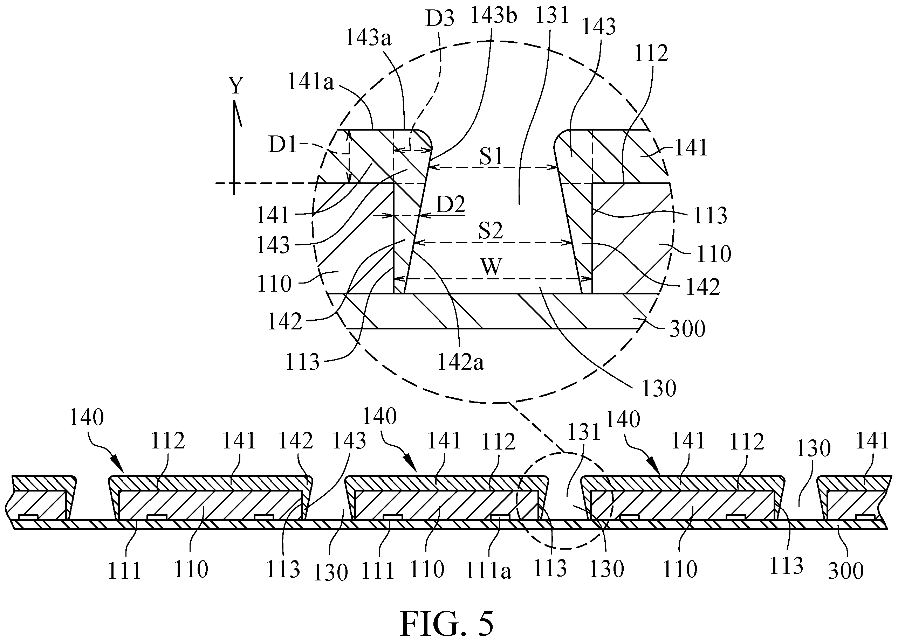

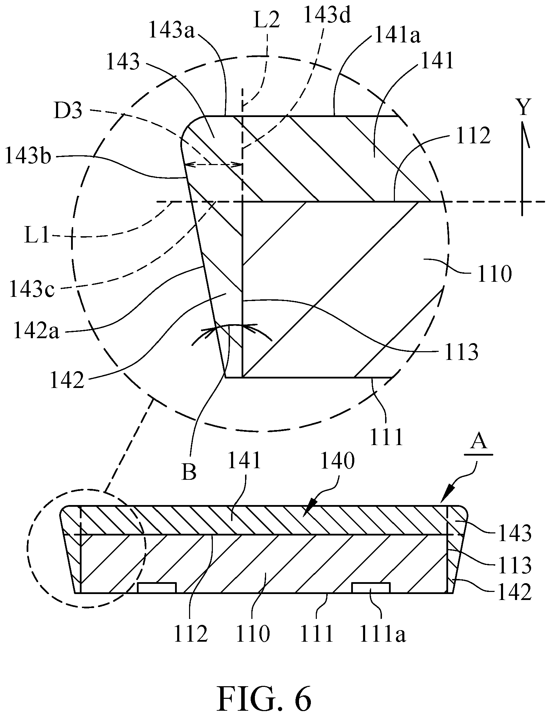

With reference to Figs. 5 and 6, a heat dissipation cover 140 is formed on the back surface 112 and the lateral surface 113 of each of the dies 110 by physical vapor deposition (PVD), sputtering, evaporation or other methods to get chip structures A, the heat dissipation cover 140 is directly formed on the back surface 112 and the lateral surface 113 to cover them. The heat dissipation cover 140 includes a first portion 141, a second portion 142 and a connection portion 143 which is located between and connected to the first portion 141 and the second portion 142. The first portion 141 is formed on the back surface 112, the second portion 142 is formed on the lateral surface 113 via the groove 130, and the connection portion 143 is formed on an outer corner of the back surface 112. Preferably, a width W of the groove 130 located between the adjacent dies 110 is designed to be greater than or equal to 10 µm and less than or equal to 2000 µm in order to allow the second portion 142 to be formed to cover the lateral surface 113. In this embodiment, the second portion 142 and the connection portion 143 are located both sides of a first imaginary line L1 which extends along the back surface 112, and the first portion 141 and the second portion 142 are located both sides of a second imaginary line L2 which extends along the lateral surface 113.

With reference to Figs. 5 and 6, the back surface 112 and the lateral surface 113 are fully covered by the first portion 141 and the second portion 142 of the heat dissipation cover 140 in this embodiment. A first exposed surface 141a of the first portion 141 corresponding to the back surface 112 has an area substantially identical to that of the back surface 112, and a second exposed surface 142a of the second portion 142 corresponding to the lateral surface 113 has an area larger than that of the lateral surface 113. The first exposed surface 141a of the first portion 141 is connected to a third exposed surface 143a of the connection portion 143, and the second exposed surface 142a of the second portion 142 is connected to a fourth exposed surface 143b of the connection portion 143. The first imaginary line L1 is located between the second exposed surface 142a and the fourth exposed surface 143b, and the second imaginary line L2 is located between the first exposed surface 141a and the third exposed surface 143a.

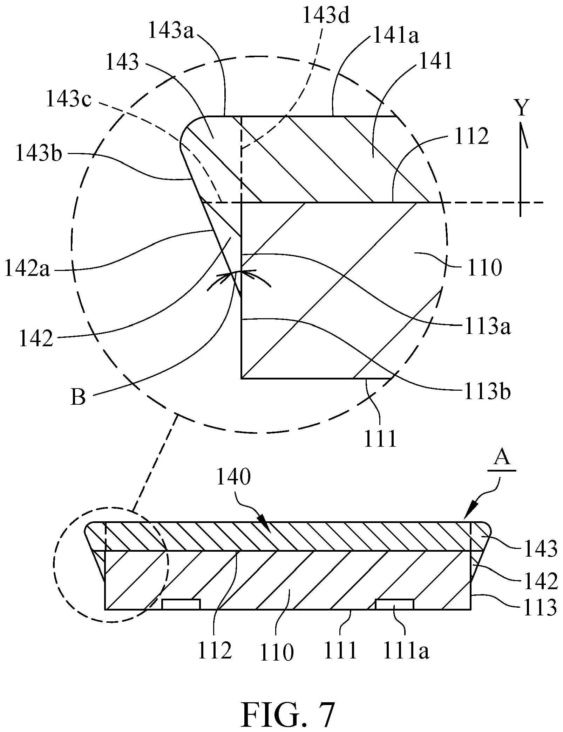

In another embodiment as shown in Fig. 7, the heat dissipation cover 140 fully covers the back surface 112 and partially covers the lateral surface 113. The second portion 142 of the heat dissipation cover 140 covers a first area 113a of the lateral surface 113 but not cover a second area 113b of the lateral surface 113. The first area 113a is adjacent to the back surface 112, the second area 113b is adjacent to the active surface 111, and the second exposed surface 142a of the second portion 142 has an area larger than that of the first area 113a.

Referring to Fig. 5, a first space S1 exists between the connection portions 143 of the adjacent heat dissipation covers 140, a second space S2 exists between the second portions 142 of the adjacent heat dissipation covers 140. The first space S1 is less than the second space S2, and the first space S1 and the second space S2 become smaller gradually from the second carrier 300 to an opening 131 of the groove 130. The first portion 141 has a first thickness D1 in a direction perpendicular to the back surface 112 (as same as the direction of an axis Y shown in Fig. 5), the second portion 142 has a second thickness D2 less than the first thickness D1 in a direction parallel to the back surface 112. The first thickness D1 is designed to be not less than 0.5 µm for better uniformity of the first portion 141 and the second portion 142. The second thickness D2 is designed to be reduced gradually in a direction from the connection portion 143 to the active surface 111 such that the second exposed surface 142a of the second portion 142 extends toward the second carrier 300 obliquely. With reference to Fig. 6, an acute angle B exists between the second exposed surface 142a of the second portion 142 and the lateral surface 113 of the die 110, the area of the second exposed surface 142a is larger than that of the lateral surface 113. In the direction parallel to the back surface 112, the connection portion 143 has a third thickness D3 which is greater than the second thickness D2 and is reduced gradually from the connection portion 143 to the second portion 142. Thus, the fourth exposed surface 143b of the connection portion 143 extends toward the second carrier 300 obliquely, and the area of the fourth exposed surface 143b can be increased. Because of the connection portion 143, mechanical strength of the heat dissipation cover 140 can be improved to prevent the second portion 142 from separating from the lateral surface 113.

With reference to Figs. 5 and 6, a first connection face 143c of the connection portion 143 is designed to be located on the first imaginary line L1, and a second connection face 143d of the connection portion 143 is designed to be located on the second imaginary line L2. Owing to the third thickness D3 of the connection portion 143 is reduced gradually in the direction toward the second portion 142, the second connection face 143d has an area larger than that of the first connection face 143c to increase the areas of the third exposed surface 143a and the fourth exposed surface 143b of the connection portion 143.

With reference to Figs. 5 to 7, after a pick and place process, the chip structures A are separated from the second carrier 300 and each includes the die 110 and the heat dissipation cover 140 which is directly formed on the back surface 112 and the lateral surface 113.

In the present invention, heat dissipation area of the heat dissipation cover 140 can be increased owing to the second exposed surface 142a of the second portion 142, the third exposed surface 143a and the fourth exposed surface 143b of the connection portion 143. The heat dissipation cover 140 is formed on the back surface 112 and the lateral surface 113 of the die 110 after dicing the wafer 100, as a result, the heat dissipation cover 140 will not be cut to generate metal debris and will not depart from the die 110 because the connection portion 143 can increase mechanical strength of the heat dissipation cover 140.

While this invention has been particularly illustrated and described in detail with respect to the preferred embodiments thereof, it will be clearly understood by those skilled in the art that is not limited to the specific features shown and described and various modified and changed in form and details may be made without departing from the scope of the claims.

## Claims

1. A method of manufacturing chip structure comprising:
attaching a wafer (100) onto a first carrier (200), the wafer (100) includes a plurality of dies (110), a back surface (112) of each of the plurality of dies (110) is attached on the first carrier (200), and an active surface (111) of each of the plurality of dies (110) is exposed; dicing the wafer (100) to singulate the plurality of dies (110) along a dicing lane (120) which is located on the active surface (111) of each of the plurality of dies (110) and located between the adjacent dies (110), a groove (130) is formed between the adjacent singulated dies (110), and a lateral surface (113) of each of the plurality of singulated dies (110) is visible from the groove (130);
attaching the diced wafer (100) onto a second carrier (300), the active surface (111) of each of the plurality of singulated dies (110) is attached on the second carrier (300);
removing the first carrier (200) to expose the groove (130), the back surface (112) and the lateral surface (113) of each of the plurality of singulated dies (110); and
forming a plurality of heat dissipation covers (140) on the plurality of singulated dies (110) to constitute a plurality of chip structures (A), each of the plurality of heat dissipation covers (140) is directly formed on the back surface (112) and the lateral surface (113) of one of the plurality of singulated dies (110) to cover the back surface (112) and the lateral surface (113), wherein each of the plurality of heat dissipation covers (140) includes a first portion (141), a second portion (142) and a connection portion (143) which is located between and connected to the first portion (141) and the second portion (142), the first portion (141) is formed on the back surface (112), the second portion (142) is formed on the lateral surface (113) via the groove (130), the connection portion (143) is formed on an outer corner of the back surface (112), there is a first space (S1) between the connection portions (143) of the adjacent heat dissipation covers (140) and a second space (S2) between the second portions (142) of the adjacent heat dissipation covers (140), the first space (S1) is less than the second space (S2), and the first space (S1) and the second space (S2) become smaller gradually from the second carrier (300) to an opening (131) of the groove (130), a first exposed surface (141a) of the first portion (141) is connected to a third exposed surface (143a) of the connection portion (143), a second exposed surface (142a) of the second portion (142) is connected to a fourth exposed surface (143b) of the connection portion (143), the first portion (141) has a first thickness (D1) in a direction perpendicular to the back surface (112), the second portion (142) has a second thickness (D2) in a direction parallel to the back surface (112), the first thickness (D1) is greater than the second thickness (D2), the second thickness (D2) is reduced gradually from the connection portion (143) to the active surface (111) such that the second exposed surface (142a) of the second portion (142) extends toward the second carrier (300) obliquely.

2. The method in accordance with claim 1, wherein the second portion (142) and the connection portion (143) are located both sides of a first imaginary line (L1) which extends along the back surface (112), the first portion (141) and the second portion (142) are located both sides of a second imaginary line (L2) which extends along the lateral surface (113), the second exposed surface (142a) has an area larger than that of the lateral surface (113).

3. The method in accordance with claim 1, wherein the second portion (142) and the connection portion (143) are located both sides of a first imaginary line (L1) which extends along the back surface (112), the first portion (141) and the second portion (142) are located both sides of a second imaginary line (L2) which extends along the lateral surface (113), the second portion (142) covers a first area (113a) of the lateral surface (113) and not cover a second area (113b) of the lateral surface (113), the first area (113a) is adjacent to the back surface (112), the second area (113b) is adjacent to the active surface (111), the second exposed surface (142a) has an area larger than that of the first area (113a) of the lateral surface (113).

4. The method in accordance with one of claims 1 to 3, wherein a first connection face (143c) of the connection portion (143) is located on a first imaginary line (L1) which extends along the back surface (112), a second connection face (143d) of the connection portion (143) is located on a second imaginary line (L2) which extends along the lateral surface (113), the second connection face (143d) has an area larger than that of the first connection face (143c).

5. The method in accordance with one of claims 1 to 4, wherein the connection portion (143) has a third thickness (D3) in the direction parallel to the back surface (112), the third thickness (D3) is greater than the second thickness (D2) of the second portion (142) and is reduced gradually from the connection portion (143) to the second portion (142), the fourth exposed surface (143b) of the connection portion (143) extends toward the second carrier (300) obliquely.

6. The method in accordance with one of claims 1 to 5, wherein a width (W) of the groove (130) is greater than or equal to 10 µm.

7. The method in accordance with one of claims 1 to 6, wherein the first thickness (D1) of the first portion (141) is greater than or equal to 0.5 µm.

8. A chip structure (A) comprising:
a die (110); and
a heat dissipation cover (140) directly formed on and covering a back surface (112) and a lateral surface (113) of the die (110), the heat dissipation cover (140) includes a first portion (141), a second portion (142) and a connection portion (143) which is located between and connected to the first portion (141) and the second portion (142), the first portion (141) is located on the back surface (112), the second portion (142) is located on the lateral surface (113), and the connection portion (143) is located on an outer corner of the back surface (112), a first exposed surface (141a) of the first portion (141) is connected to a third exposed surface (143a) of the connection portion (143), a second exposed surface (142a) of the second portion (142) is connected to a fourth exposed surface (143b) of the connection portion (143), the first portion (141) has a first thickness (D1) in a direction perpendicular to the back surface (112), the second portion (142) has a second thickness (D2) in a direction parallel to the back surface (112), the first thickness (D1) is greater than the second thickness (D2), the second thickness (D2) is reduced gradually from the connection portion (143) to an active surface (111) of the die (110), and there is an acute angle (B) between the second exposed surface (142a) of the second portion (142) and the lateral surface (113) of the die (110).

9. The chip structure (A) in accordance with claim 8, wherein the second portion (142) and the connection portion (143) are located both sides of a first imaginary line (L1) which extends along the back surface (112) of the die (110), the first portion (141) and the second portion (142) are located both sides of a second imaginary line (L2) which extends along the lateral surface (113) of the die (110), the second exposed surface (142a) of the second portion (142) has an area larger than that of the lateral surface (113) of the die (110).

10. The chip structure (A) in accordance with claim 8, wherein the second portion (142) and the connection portion (143) are located both sides of a first imaginary line (L1) which extends along the back surface (112) of the die (110), the first portion (141) and the second portion (142) are located both sides of a second imaginary line (L2) which extends along the lateral surface (113) of the die (110), the second portion (142) covers a first area (113a) of the lateral surface (113) of the die (110) and not cover a second area (113b) of the lateral surface (113) of the die (110), the first area (113a) is adjacent to the back surface (112) of the die (110), the second area (113b) is adjacent to the active surface (111) of the die(110), the second exposed surface (142a) of the second portion (142) has an area larger than that of the first area (113a) of the lateral surface (113) of the die (110).

11. The chip structure (A) in accordance with one of claims 8 to 10, wherein a first connection face (143c) of the connection portion (143) is located on a first imaginary line (L1) which extends along the back surface (112) of the die (110), a second connection face (143d) of the connection portion (143) is located on a second imaginary line (L2) which extends along the lateral surface (113) of the die (110), the second connection face (143d) has an area larger than that of the first connection face (143c).

12. The chip structure (A) in accordance with one of claims 8 to 11, wherein the connection portion (143) has a third thickness (D3) in the direction parallel to the back surface (112) of the die (110), the third thickness (D3) is greater than the second thickness (D2) of the second portion (142) and is reduced gradually from the connection portion (143) to the second portion (142).

13. The chip structure (A) in accordance with one of claims 8 to 12, wherein the first thickness (D1) of the first portion (141) is greater than or equal to 0.5 µm.
